# EUROPÄISCHE PATENTSCHRIFT

(11) **EP 3 669 145 B1**
(45) Veröffentlichungstag und Bekanntmachung des Hinweises auf die Patenterteilung: **25.05.2022**
(21) Anmeldenummer: 18753387.2
(22) Anmeldetag: 09.08.2018
(51) Int. Cl.: G01D 5/18, G01D 5/244, G01D 21/00

(54) **STEUERGERÄT MIT SCHALTUNG UND VERFAHREN ZUM KURZSCHLUSSSCHUTZ VON MASSELEITUNGEN UND SENSOREN**
CONTROL UNIT COMPRISING A CIRCUIT, AND METHOD FOR SHORT-CIRCUIT PROTECTION OF GROUND LINES AND SENSORS
APPAREIL DE COMMANDE POURVU D'UN COMMUTATEUR ET PROCÉDÉ DE PROTECTION CONTRE LES COURTS-CIRCUITS DE CÂBLES DE MASSE ET CAPTEURS

(30) Priorität: 15.08.2017 DE 102017214205
(43) Veröffentlichungstag der Anmeldung: 24.06.2020
(73) Patentinhaber: Robert Bosch GmbH, 70442 Stuttgart (DE)
(72) Erfinder: BRUCKHAUS, Tim, 71679 Asperg (DE)
(86) Internationale Anmeldenummer: PCT/EP2018/071584
(87) Internationale Veröffentlichungsnummer: WO 2019/034510

(56) Entgegenhaltungen:
- EP-A1- 0 846 955
- EP-A1- 2 660 843
- DE-A1- 19 534 825
- DE-A1-102013 206 412
- US-A1- 2012 033 337

## Beschreibung

### Stand der Technik

Die Erfindung betriff ein Steuergerät mit einer Schaltung und Verfahren zum Kurzschlussschutz von Masseleitungen und Sensoren. Zur Auswertung resistiver Sensoren, (z. B. NTC-Temperatursensoren, NTC = Negative Temperature Coefficient) wird häufig mit Hilfe eines (weiteren) ersten Widerstandes, der mit dem Sensor in Serie geschaltet ist, ein Spannungsteiler gebildet, durch den ein analoges Spannungssignal generiert wird.

Das Dokument EP 2 660 843 A1 offenbart einen Schaltkreisunterbrecher, welcher dazu eingerichtet ist, eine Last von einer Versorgungsspannung zu trennen. Das Dokument US 2012/033337 A1 offenbar eine Schaltungsanordnung und ein Verfahren zur Simulation eines Sensors. Das Dokument DE 195 34 825 A1 offenbart eine Schaltungsanordnung zum Auswerten eines binären, durch zwei Stromschwellenwerte definiertes Signals, insbesondere des Ausgangssignals eines aktiven Sensors. Das Dokument DE 10 2013 206 412 A1 offenbart eine Schutzschaltung für eine Signalausgangs-Stufe.

Das Spannungssignal kann z. B. mit einem Analog-Digital-Wandler in einem Steuergerät erfasst und weiterverarbeitet werden. Der Spannungsteiler ist dabei so aufgebaut, dass ein Anschluß des Sensors auf einer Erdung bzw. einem Bezugspotential liegt und der andere Anschluß an den ersten Widerstand angeschlossen ist. Der erste Widerstand wird in diesem Zusammenhang häufig auch "Pull-Up-Widerstand" genannt. Der erste Widerstand ist an einem dem Sensor gegenüberliegenden Ende an eine Versorgungsspannungsquelle angeschlossen. Zwischen erstem Widerstand und dem Sensor wird das Signal gegriffen, welches das Steuergerät zur Auswertung der mit dem Sensor gemessenen Messgröße misst.

Eine solche Anordnung wird z.B. häufig in Kraftfahrzeugen verwendet, um einem Steuergerät z.B. die Messung einer Temperatur außerhalb des Steuergerätes zu ermöglichen. Ein weiterer Anwendungsfall einer solchen Anordnung liegt in Hybrid- und Elektrofahrzeugen vor, in denen mit solchen Anordnungen die Temperatur elektrischer Maschinen erfasst werden kann. Die Leitungen, die den Sensor kontaktieren, laufen dabei gegebenenfalls außerhalb des Steuergerätes über den Kraftfahrzeugkabelbaum. Es ist aber auch möglich, dass Leitungen über ein separates Kabel vom Steuergerät zur elektrischen Maschine geführt sind.

### Offenbarung der Erfindung

Im Automobilbereich besteht im Allgemeinen die Anforderung, dass die weiter oben beschriebene Anordnung einen Kurzschluss einer der beiden Sensorleitungen, an die der Sensor angeschlossen ist, und den in der Folge ggf. fließenden Kurzschlussstrom unbeschadet überstehen soll.

Ein Kurzschlussstrom ist hier im Allgemeinen als ein Strom zu verstehen, der über eine der Sensorleitungen fließt und welcher einen definierten Grenzstrom übersteigt. Ein solcher Strom kann beispielsweise auftreten, wenn an einer der beiden Sensorleitungen (erste Sensorleitung und zweite Sensorleitung) eine große Spannung anliegt. Die Betriebsspannung des Bordnetzes, die beispielsweise 14 Volt beträgt, reicht häufig schon aus, um bei einem Kurzschluss zu dieser Spannung einen Strom fließen zu lassen, der den Sensor, die Leitungen oder die Schaltung überlasten.

Ein Kurzschluss ist hier als eine ungewollte, niederohmige elektrische Verbindung zu einem Signal zu verstehen, welches eine Spannung führen kann, durch die Ströme durch den Sensor, über die Leitungen oder in das Steuergerät fließen können, die deutlich größer als die Betriebsströme im regulären Betrieb sein können.

Bei Leitungen, die im Steuergerät hochohmig angebunden sind, bei denen also das Steuergerät selbst schon einen hochohmigen Widerstand bildet, ist ein Kurzschlussschutz häufig bereits durch die hochohmige Dimensionierung der Schaltung im Steuergerät gegeben.

Dennoch besteht für den Sensor das Risiko der Überlastung und Zerstörung durch einen Kurzschluss, da über den Sensor dann trotzdem die volle Bordnetzspannung (von beispielsweise 14 Volt) anliegen kann. Wenn beispielsweise an einer ersten Leitung des Sensors, welche an der der Erdung gegenüber liegenden Seite angeschlossen ist, die volle Bordnetzspannung von 14 Volt auftritt, kann der Sensor durch Überlastung zerstört werden, weil er für eine solche Spannung nicht ausgelegt ist.

Diese Problematik wird verstärkt, wenn es sich z. B. um einen NT-Temperatursensor (NTC = Negative Temperature Coefficient) handelt. Der Widerstand eines solchen NTC-Temperatursensors sinkt mit zunehmender Erwärmung weiter, so dass sich die Verlustleistung immer weiter erhöht. Reicht die Entwärmung des Sensors zum Abführen dieser Erwärmung nicht aus, führt diese Mitkopplung häufig zur Zerstörung des Sensors.

Bei Leitungen, die im Steuergerät niederohmig angebunden sind (z. B. Masseleitungen von Sensoren), ist ein Kurzschlussschutz unabhängig vom Verhalten des Sensors nicht gegeben. Ein Kurzschluss gegen Spannungen, die vom Bezugspotential des Steuergeräts (normalerweise die Erdung) abweichen, kann zur Zerstörung der Leitungen zu dem Sensor, des Steuergerätes oder des Sensors führen. Aus Gründen der Messgenauigkeit kann aber oft nicht auf eine niederohmige Anbindung eines der Sensoranschlüsse verzichtet werden.

Mit dem hier vorgestellten Steuergerät und dem entsprechenden Betriebsverfahren sollen sowohl der Sensor als auch niederohmig angebundene Zuleitungen zum Sensor im Falle eines Kurzschlusses vor Überlastung und Zerstörung geschützt werden. Dies soll ohne einen signifikanten Verlust an Messgenauigkeit erreicht werden.

Das hier beschriebene Steuergerät zur Auswertung des Sensorsignals eines Sensors weist mindestens einen ersten Sensoranschluss zum Anschließen des Sensors auf, wobei der erste Sensoranschluss mit einer Kurzschlussschutzschaltung verbunden ist, die zwischen dem ersten Sensoranschluss und einer Erdung angeordnet ist und welche einen schaltbaren Transistor umfasst, mit welchem die Erdung des ersten Sensoranschlusses unterbrochen werden kann. Mit dem schaltbaren Transistor der Kurzschlussschutzschaltung kann eine Erdung des ersten Sensoranschlusses unterbrochen werden. So kann verhindert werden, dass durch den ersten Sensoranschluss ein Kurzschlussstrom auftreten kann. Der erste Sensoranschluss ist bevorzugt ein niederohmiger Sensoranschluss, über welchen ohne die beschriebene Kurzschlussschutzschaltung schnell ein Kurzschlussstrom auftreten könnte.

Der Transistor ist beispielsweise ein MOSFET (MOSFET = Metall-Oxid-Halbleiter-Feldeffekttransistor) oder ein vergleichbares Bauteil.

Durch eine Unterbrechung des Stromfluss durch den Sensor mit dem Transistor kann eine Zerstörung von dem Steuergerät, dem Sensor oder der Leitung verhindert werden. Gleichzeitig ist der Einfluss der Kurzschlussschutzschaltung auf die Genauigkeit der Sensorauswertung bei entsprechender Dimensionierung sehr gering.

Wie beschrieben ist der Sensor insbesondere ein resistiver Sensor und besonders bevorzugt ein Temperatursensor, der wiederum bevorzugt ein NTC-Sensor (NTC = Negative Temperature Coefficient) ist. Der hier behandelte Kurzschlussschutz ist allerdings nicht auf ein spezielles Sensorprinzip beschränkt. Bei NTC-Sensoren kommt allerdings der Vorteil der hier beschriebenen Kurzschluss-Schutzschaltung besonders zum Tragen, weil NTC-Sensoren bei Erwärmung immer niederohmiger werden und der Kurzschlussstrom somit immer weiter steigt, wenn durch den Kurzschlussstrom eine Eigenerwärmung des Sensors auftritt. Diese Steigerung erfolgt bis der Sensor oder die Leitung zerstört. Somit ist bei NTC-Sensoren sowohl ein Kurzschluss an einer Masseleitung als auch ein Kurzschluss an einer Signalleitung kritisch.

Das Steuergerät hat bevorzugt weiter einen zweiten Sensoranschluss zum Anschließen des Sensors und zur Bereitstellung einer Sensorspannung zum Betrieb des Sensors, wobei der zweite Sensoranschluss an eine Spannungsquelle angeschlossen ist. Die Spannungsquelle dient dazu, dass über dem Sensor eine Spannung anliegt. Diese Spannung ist dazu notwendig, dass durch den Sensor ein Messstrom fließt, welcher zur Nutzung des Messprinzips des Sensors erforderlich ist.

Für den Anschluß einer ersten Sensorleitung gibt es zwei gängige Varianten. Gemäß einer ersten Variante ist die erste Sensorleitung direkt an eine Versorgungsspannung angeschlossen. Dies kommt zum Einsatz, wenn es sich um einen aktiven Sensor handelt, der sein Ausgangssignal selbst erzeugt. Gemäß einer zweiten Variante ist die erste Sensorleitung ist über einen (zusätzlichen) (ersten) Widerstand an die Versorgungsspannung angeschlossen.

Der erste Widerstand wird beispielsweise auch Pull-Up-Widerstand genannt. Dieser erste Widerstand wirkt mit dem Widerstand des Sensors als

Spannungsteiler, um den Sensor mittels des Sensorsignals auswerten zu können. Dieser Widerstand definiert zusammen mit dem Sensorwiderstand die über den Sensor anliegende Sensorspannung.

Der Transistor ist in einem Unterbrechungspfad angeordnet, in welchem sich in Serie zu dem Transistor ein niederohmiger zweiter Widerstandbefinden kann.

Der zweite niederohmige Widerstand kann in Varianten auch entfallen bzw. auch von dem Transistor gebildet werden, welcher üblicherweise auch einen (niederohmigen) Eigenwiderstand aufweist.

Wenn der Transistor geschlossen ist und ein Kurzschlussstrom durch den Transistor fließen kann, hilft dieser niederohmige Widerstand, den Kurzschlussstrom zu begrenzen. Mit der Bezeichnung "niederohmig" ist hier insbesondere gemeint, dass dieser Widerstand im Vergleich zu dem ersten Widerstand und dem im Folgenden noch beschriebenen dritten Widerstand gering ist.

Eine Strombegrenzung kann die Reaktionszeit, bis zu der ein Kurzschlussfall erkannt werden muss und der Transistor der Kurzschlussschutzschaltung geöffnet werden muss, verlängern. Zur Strombegrenzung kann der optionale zweite Widerstand dienen, weil er eine Stromgegenkopplung des Transistors bewirkt. Eine gewisse Strombegrenzung ist auch ohne die Verwendung des zweiten Widerstandes gegeben, weil der Transistor abhängig von der eingestellten Gate-Source-Spannung beim Kurzschluss im Abschnürrbereich betrieben wird und damit ebenfalls eine strombegrenzende Wirkung besitzt. Insbesondere MOSFETs verhalten sich im Abschnürrbereich allerdings nicht nicht mehr wie ein Widerstand.

Je nach Dimensionierung des Transistors und seiner Gate-Spannung kann so auch eine dauerhafte Robustheit gegen Kurzschlüsse realisiert sein. Das Gate von dem Transistor kann hierzu auf einem festen Potential liegen und eine intelligente Ansteuerung des Gates über eine Ansteuerungsschaltung könnte entfallen. Diese (einfache) Schaltung wird auch "Clamping-Schaltung" genannt. Außerdem vorteilhaft ist es, wenn die Kurzschlussschutzschaltung einen Umgehungspfad aufweist, mit welchem der Transistor überbrückt wird, in welchem sich ein hochohmiger dritter Widerstand befindet.

Mit der Bezeichnung "hochohmig" ist hier gemeint, dass der dritte Widerstand insbesondere im Vergleich zu dem zweiten Widerstand und dem ersten Widerstand sehr groß ist. Dieser Widerstand führt zu einem permanenten Stromabfluss, unabhängig davon, ob der Transistor geöffnet ist oder nicht.

Dieser dritte Widerstand wird auch als Pull-Down-Widerstand bezeichnet. Der dritte Widerstand ermöglicht es, zu unterscheiden, ob ein Kurzschluss an einer Leitung zu dem Sensor oder an einer zweiten Leitung zu dem Sensor vorliegt, wenn der Transistor geöffnet ist.

In dem Steuergerät ist bevorzugt eine Auswerteschaltung vorgesehen, an welche zumindest der erster Sensoranschluss angebunden ist, und die dazu eingerichtet ist, ein Sensorsignal eines an den ersten Sensoranschluss angeschlossenen Sensors auszuwerten. Zur Auswertung des Sensors ist in erster Linie das Signal am zweiten Sensoranschluss (zwischen Pull-Up und Sensor) gedacht. Optional kann zur Auswertung auch zusätzlich das Signal am ersten Sensoranschluss zwischen Sensor und Schutzschaltung verwendet werden, wie nachfolgend auch noch im Detail beschrieben wird.

Die Auswerteschaltung kann zudem dazu eingerichtet sein, das Sensorsignal eines an einen zweiten Sensoranschluss angeschlossen Sensors auszuwerten, wozu auch ein zweiter Sensoranschluss an die Auswerteschaltung angebunden sein kann.

Der erste Sensoranschluss und der zweiten Sensoranschluss sind bevorzugt an einander gegenüberliegende Pole, Enden oder Anschlüsse des Sensors angeschlossen. Eine Sensorspannung zwischen dem ersten Sensoranschluss und der Erdung wird als erstes Sensorsignal bezeichnet. Eine Sensorspannung zwischen dem zweitem Sensoranschluss und der Erdung wird als zweites Sensorsignal bezeichnet. Die Differenzspannung zwischen dem ersten Sensorsignal und dem zweiten Sensorsignal wird als zweites Sensorsignal bezeichnet.

Zur Auswertung des Sensors über ein erstes Sensorsignal ist der Transistor geschlossen. Der Transistor und der gegebenenfalls vorhandene zweite Widerstand sind bevorzugter Weise so niederohmig dimensioniert, dass der Spannungsabfall über den zweiten Widerstand und dem Transistor gegenüber dem Spannungsabfall über dem Sensor und dem ersten Widerstand vernachlässigbar ist.

Ist der Spannungsabfall über den Transistor und den zweiten Widerstand nicht vernachlässigbar und nicht hinreichend bekannt, so kann auch das zweite Sensorsignal zwischen dem ersten Sensoranschluss und dem zweiten Sensoranschluss ausgewertet werden. Es reicht zur Auswertung resistiver Sensoren das Signal zwischen Sensor und Pull-Up-Widerstand, wenn der Widerstand des Transistors und des Widerstandes unter dem Transistors bekannt sind.

Das Steuergerät umfasst eine Ansteuerungsschaltung, mit welcher die Kurzschlussschutzschaltung (bzw. der Transistor der

Kurzschlussschutzschaltung) angesteuert werden kann, um einen Kurzschluss zu verhindern.

Eine Kurzschlusserkennung kann insbesondere gemäß den folgenden Varianten erfolgen:
- Auswertung Spannungsabfall über Transistor und Widerstand und Vergleich mit Schwellwert/erwarteten Werten,
- Auswertung Spannung am Sensorsignal zwischen Sensor und erstem-Widerstand (Pull-Up-Widerstand) und Vergleich mit Schwellwert/erwarteten Werten, oder Detektion der Spannungsabfälle über den Widerständen, sowie Berechnung der Ströme und Stromdifferenzen. Wenn kein Kurzschluss vorhanden ist, sind die Ströme gleich. Ist ein Kurzschluss vorhanden, sorgt der Strom, der über den Kurzschluss in die Schaltung rein- bzw. ausfließt, für eine Differenz der Ströme.

Die Unterbrechung der Kurzschlussschutzschaltung bzw. der Erdung verhindert den weiteren Kurzschluss.

Die Ansteuerung des Transistors mit Hilfe einer Ansteuerungsschaltung erfordert die Erkennung eines Kurzschlusses. Dies kann über die erste Leitung und die zweite Leitung bzw. anhand des beschriebenen ersten Sensorsignals und/oder des beschriebenen zweiten Sensorsignals erreicht werden. Zum Erkennen eines Kurzschlusses ist der Transistor bevorzugt geöffnet. (

Die Prüfung, ob ein Kurzschluss an der ersten Leitung oder an der zweiten Leitung anliegt, wird auch "Pin-Pointing" genannt. Zur Prüfung, ob ein Kurzschluss an der ersten Leitung oder an der zweiten Leitung anliegt, dient der dritte Widerstand. Ist der dritte Widerstand nicht vorhanden und der Transistor geöffnet, so liegen an der ersten Leitung und an der zweiten Leitung in beiden Kurzschlussfällen (Kurzschluss an der ersten Leitung und Kurzschluss an der zweiten Leitung) die gleichen Spannungen an, da über den Sensor kein Strom fließen kann. Eine Unterscheidung ist dann nicht möglich. Ist der dritte Widerstand vorhanden, so stellen sich je nach Kurzschluss an der ersten Leitung oder an der zweiten Leitung unterschiedliche Spannungen ein. Damit ist eine Unterscheidung zwischen einem Kurzschluss an der ersten Leitung oder einem Kurzschluss an der zweiten Leitung möglich.

Hier auch beschrieben werden soll ein Verfahren zum Betrieb eines Sensors mit einem Steuergerät nach einem der vorhergehenden Ansprüche aufweisend zumindest eine der folgenden Maßnahmen:
- Schließen des Transistors, wenn erkannt wurde, dass kein Kurzschluss vorliegt,
- Öffnen des Transistors, wenn erkannt wurde, dass ein Kurzschluss vorliegt,
- Schließen des Transistors vor einem Messzeitpunkt, Durchführen einer Messung mit dem Sensor und anschließendes Öffnen des Transistors.

Die beschriebenen Maßnahmen können einzeln oder in Kombination durchgeführt werden, um mit dem beschriebenen Steuergerät einen effektiven Kurzschlussschutz für einen Sensor zu erreichen.

Besonders vorteilhaft erfolgt bei dem Betrieb des Sensors eine Erkennung eines Kurzschlusses, wenn ein unerwarteter Unterschied zwischen einem ersten Sensorsignal an einem ersten Sensoranschluss und einer Erdung und einem zweiten Sensorsignal zwischen einem ersten Sensoranschluss und einem zweiten Sensoranschluss vorliegt.

Besonders vorteilhaft ist das Verfahren auch, wenn zur Erkennung eines Kurzschlusses der Spannungsabfall über mindestens einen ersten Widerstand oder einen zweiten Widerstand durch ein Steuergerät erfasst wird. Es können auch sowohl der Spannungsabfall über den ersten Widerstand als auch der Spannungsabfall über den zweiten Widerstand erfasst werden, um einen Kurzschluss besonders präzise zu erkennen.

Außerdem besonders vorteilhaft ist das Verfahren, wenn die Spannungsfälle mit Schwellwerten verglichen werden, um einem Kurzschluss zu erkennen.

Weiterhin besonders vorteilhaft ist das Verfahren, wenn die Änderung mindestens eines Spannungsfalls mit mindestens einem Schwellwert verglichen wird, um einem Kurzschluss zu erkennen.

Darüber hinaus können mittels zweier erfasster Spannungsabfälle über einen ersten Widerstande und/oder einen zweiten Widerstand die Ströme durch den ersten Widerstand bzw. den zweiten Widerstand in einem Steuergerät berechnet werden. Durch den Vergleich der Differenz der Ströme kann ein Kurzschluss erkannt werden.

Gemäß einer weiteren Betriebsweise bleibt der Transistor dauerhaft geschlossen. Im Falle eines Kurzschlusses wird der Strom durch den Sensor, den Transistor und dem zweiten Widerstand (passiv) auf ein tragbares Maß begrenzt.

Die Offenbarung wird nachfolgend anhand der Figuren näher erläutert. Es ist darauf hinzuweisen, dass die in den Figuren dargestellten Größenverhältnisse nur schematisch sind. Merkmale aus den Figuren sind beliebig miteinander kombinierbar. Es zeigen:
- Fig. 1:: eine bekanntes Steuergerät zur Auswertung eines Sensors und
- Fig. 2:: das hier beschriebene Steuergerät zur Auswertung eines Sensors.

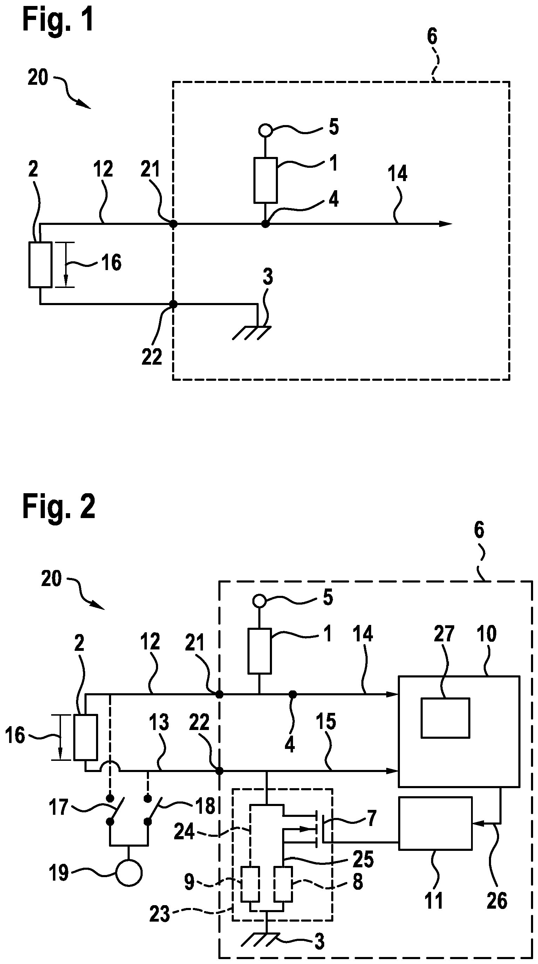

In Fig. 1 ist ein Steuergerät 6 zu sehen, welches einen ersten Sensoranschluss 21 zum Anschluß einer ersten Leitung 12 eines Sensors 2 und einen zweiten Sensoranschluss 22 zum Anschluß einer zweiten Leitung 13 eines Sensors 2 aufweist. Der zweite Sensoranschluss 22 ist auf Seiten bzw. innerhalb des Steuergerätes 6 an eine Erdung 3 angeschlossen. Der erste Sensoranschluss 21 ist auf Seiten bzw. innerhalb des Steuergerätes 6 mit einer Versorgungsspannungsquelle 5 verbunden, wobei zwischen der Versorgungsspannungsquelle 5 und dem ersten Sensoranschluss 21 bzw. dem Sensor 2 noch ein erster Widerstand 1 angeordnet ist. Innerhalb des Steuergerätes 6 existiert zwischen dem ersten Widerstand 1 und dem Sensor 2 ein Signalanschluß 4, an welchem ein erstes Sensorsignal 14 des Sensors 2 zur Auswertung abgegriffen werden kann.

Das hier beschriebene und in Fig. 2 dargestellte Steuergerät 6 ist entsprechend zu dem Steuergerät 6 in Fig. 1 aufgebaut. Zusätzlich weist es allerdings zwischen dem zweiten Sensoranschluss 22 bzw. dem Sensor 2 und der Erdung 3 eine Kurzschlussschutzschaltung 23 auf, die den Sensor 2 und das Steuergerät 6 sowie die Leitungen (insbesondere die erste Leitung 12 und die zweite Leitung 13) vor Kurzschlüssen schützt.

Die Kurzschlussschutzschaltung 23 hat zwei parallele Pfade, nämlich einen Unterbrechungspfad 25 und einen Überbrückungspfad 24, die parallel zueinander angeordnet sind und eine Erdung des zweiten Sensoranschlusses 22 darstellen. Der Überbrückungspfad 24 hat einen hochohmigen dritten Widerstand 9. Der Unterbrechungspfad 25 hat in Serie einen Transistor 7 und einen niederohmigen zweiten Widerstand 8. Der Unterbrechungspfad 25 kann mit dem Transistor 7 gezielt geöffnet und geschlossen werden, um ggf. einen Kurzschlussschutz zu erreichen.

Die beiden möglichen Kurzschlussfälle sind in der Fig. 2 schematisch anhand der Kurzschlussspannungsquelle 19 dargestellt, die ein Potential auf den Sensor 2 bzw. auf das Steuergerät 6 beaufschlagen kann. Als Schalter dargestellt sind ein erster Kurzschluss 17 auf der ersten Leitung 12 sowie ein zweiter Kurzschluss 18 auf der zweiten Leitung 13.

Das in Fig. 2 dargestellte Steuergerät 6 ermöglicht nicht nur ein erstes Sensorsignal 14 auszuwerten, das auch bei dem Steuergerät 6 gemäß Fig. 1 ausgewertet werden kann, sondern zusätzlich auch die Auswertung eines zweiten Sensorsignals 15, welches ein Differenzsignal zwischen dem ersten Sensoranschluss 21 und dem zweiten Sensoranschluss 22 bildet. Zur Auswertung ist hier auch eine Auswerteschaltung 10 dargestellt, die üblicherweise auch einen Analog-Digital-Wandler 27 umfasst, mit welchem das analoge Spannungssignal des Sensors 2 in ein digitales Signal zur weiteren Auswertung umgewandelt werden kann. Hier ebenfalls dargestellt ist eine Ansteuerungsschaltung 11, die den Transistor 7 ansteuern kann und die von der Auswerteschaltung 10 ein Signal 26 hinsichtlich der auftretenden Spannungen an dem ersten Anschluß 21 und an dem zweiten Anschluß 22 erhalten kann, um einen Kurzschluss zu erkennen und den Transistor 7 ggf. zu öffnen oder auch wieder zu schließen.

## Patentansprüche

1. Steuergerät (6) zur Auswertung des Sensorsignals eines Sensors (2) aufweisend mindestens einen ersten Sensoranschluss (21) und einen zweiten Sensoranschluss (22) zum Anschließen des Sensors (2), wobei das Steuergerät eine Kurzschlussschutzschaltung (23) umfasst und der zweite Sensoranschluss (22) mit der Kurzschlussschutzschaltung (23) verbunden ist, die zwischen dem zweiten Sensoranschluss (22) und einer Erdung (3) angeordnet ist und welche einen schaltbaren Transistor (7) umfasst, mit welchem die Erdung (3) des zweiten Sensoranschlusses (22) unterbrochen werden kann.

2. Steuergerät (6) nach Anspruch 1, wobei der erste Sensoranschluss (21) zum Anschließen des Sensors (2) und zur Bereitstellung einer Sensorspannung zum Betrieb des Sensors (2) eingerichtet ist, wobei der erste Sensoranschluss (21) an eine Versorgungsspannungsquelle (5) angeschlossen ist.

3. Steuergerät (6) nach Anspruch 2, wobei zwischen der Versorgungsspannungsquelle (5) und dem Sensor (2) ein erster Widerstand (1) angeordnet ist.

4. Steuergerät (6), nach einem der vorhergehenden Ansprüche, wobei der Transistor (7) in einem Unterbrechungspfad (25) angeordnet ist, in welchem sich in Serie zu dem Transistor (7) ein niederohmiger zweiter Widerstand (8) befindet.

5. Steuergerät (6) nach einem der vorhergehenden Ansprüche, wobei die Kurzschlussschutzschaltung (23) einen Überbrückungspfad (24) aufweist, mit welchem der Transistor (7) überbrückt wird und in welchem sich ein hochohmiger dritter Widerstand (9) befindet.

6. Steuergerät (6) nach einem der vorhergehenden Ansprüche, umfassend eine Auswerteschaltung (10), an welche zumindest der erste Sensoranschluss (21) angebunden ist, und die dazu eingerichtet ist, ein Sensorsignal eines an den ersten Sensoranschluss (21) angeschlossenen Sensors (2) auszuwerten.

7. Steuergerät (6) nach Anspruch 6, wobei die Auswerteschaltung (10) zusätzlich an den zweiten Sensoranschluss (22) angebunden ist und bei der Auswertung eines Sensorsignals eines an den ersten Sensoranschluss (21) und an den zweiten Sensoranschlusses (22) angebundenen Sensors wahlweise auf eine Sensorspannung (16) zwischen dem ersten Sensoranschluss (21) und einer Erdung (3) oder auf eine Sensorspannung (16) zwischen dem ersten Sensoranschluss (21) und dem zweiten Sensoranschluss (22) zurückgreifen kann.

8. Steuergerät (6) nach einem der vorhergehenden Ansprüche umfassend eine Ansteuerungsschaltung (11), mit welcher die Kurzschlussschutzschaltung (23) angesteuert werden kann, um einen Kurzschluss zu verhindern.

9. Steuergerät (6) nach Anspruch 8, wobei die Ansteuerungsschaltung (11) dazu eingerichtet ist, die Kurzschlussschutzschaltung (23) zu unterbrechen, wenn ein unerwarteter Unterschied zwischen einem ersten Sensorsignal (14) an einem ersten Sensoranschluss (21) und einer Erdung (3) und einem zweiten Sensorsignal (15) zwischen dem ersten Sensoranschluss (21) und dem zweiten Sensoranschluss (22) vorliegt.

10. Verfahren zum Betrieb eines Sensors (2) mit einem Steuergerät (6) nach einem der vorhergehenden Ansprüche aufweisend zumindest eine der folgenden Maßnahmen:
- Schließen des Transistors, wenn erkannt wurde, dass kein Kurzschluss vorliegt,
- Öffnen des Transistors, wenn erkannt wurde, dass ein Kurzschluss vorliegt,
- Schließen des Transistors vor einem Messzeitpunkt, Durchführen einer Messung mit dem Sensor und anschließendes Öffnen des Transistors.

11. Verfahren zum Betrieb eines Sensors (2) nach Anspruch 10, wobei zur Erkennung eines Kurzschlusses der Spannungsabfall über mindestens einen ersten Widerstand (1) oder einen zweiten Widerstand (8) durch ein Steuergerät (27) erfasst wird.

12. Verfahren zum Betrieb eines Sensors (2) nach Anspruch 11, wobei der oder die Spannungsabfälle mit Schwellwerten verglichen werden, um einen Kurzschluss zu erkennen.

13. Verfahren zum Betrieb eines Sensors (2) nach Anspruch 11, wobei die Änderung mindestens eines Spannungsabfalls mit mindestens einem Schwellwert verglichen wird, um einem Kurzschluss zu erkennen.

14. Verfahren zum Betrieb eines Sensors (2) nach Anspruch 11, wobei mittels zweier erfasster Spannungsabfälle über einen ersten Widerstande (1) oder einen zweiten Widerstand (8) die Ströme durch den ersten Widerstand (1) bzw. den zweiten Widerstand (8) in einem Steuergerät (27) berechnet werden, und durch den Vergleich der Differenz der Ströme ein Kurzschluss erkannt werden kann.

## Claims

1. Control unit (6) for evaluating the sensor signal from a sensor (2), comprising at least one first sensor connection (21) and a second sensor connection (22) for connecting the sensor (2), wherein the control unit comprises a short-circuit protection circuit (23) and the second sensor connection (22) is connected to the short-circuit protection circuit (23), which is arranged between the second sensor connection (22) and an earthing (3), and which comprises a switchable transistor (7), by way of which the earthing (3) of the second sensor connection (22) can be interrupted.

2. Control unit (6) according to Claim 1, wherein the first sensor connection (21) is configured to connect the sensor (2) and to provide a sensor voltage to operate the sensor (2), wherein the first sensor connection (21) is connected to a supply voltage source (5).

3. Control unit (6) according to Claim 2, wherein a first resistor (1) is arranged between the supply voltage source (5) and the sensor (2).

4. Control unit (6) according to any one of the preceding claims, wherein the transistor (7) is arranged in a circuit breaker path (25) in which a low-impedance second resistor (8) is placed in series with the transistor (7).

5. Control unit (6) according to any one of the preceding claims, wherein the short-circuit protection circuit (23) comprises a bypass path (24), by way of which the transistor (7) is bypassed and in which a high-impedance third resistor (9) is placed.

6. Control unit (6) according to any one of the preceding claims, comprising an evaluation circuit (10), to which at least the first sensor connection (21) is connected, and which is configured to evaluate a sensor signal from a sensor (2) connected to the first sensor connection (21).

7. Control unit (6) according to Claim 6, wherein the evaluation circuit (10) is additionally connected to the second sensor connection (22) and, during the evaluation of a sensor signal from a sensor, which is connected to the first sensor connection (21) and to the second sensor connection (22), can resort either to a sensor voltage (16) between the first sensor connection (21) and an earthing (3), or to a sensor voltage (16) between the first sensor connection (21) and the second sensor connection (22) .

8. Control unit (6) according to any one of the preceding claims, comprising a control circuit (11), by way of which the short-circuit protection circuit (23) can be controlled to prevent a short circuit.

9. Control unit (6) according to Claim 8, wherein the control circuit (11) is configured to interrupt the short-circuit protection circuit (23) when an unexpected difference exists between a first sensor signal (14) at a first sensor connection (21) and an earthing (3) and a second sensor signal (15) between the first sensor connection (21) and the second sensor connection (22).

10. Method for operating a sensor (2) comprising a control unit (6) according to any one of the preceding claims, having at least one of the following measures:
- closing the transistor if it has been detected that there is no short circuit present,
- opening the transistor if it has been detected that a short circuit is present,
- closing the transistor before a measuring time, performing a measurement with the sensor and subsequently opening the transistor.

11. Method for operating a sensor (2) according to Claim 10, wherein to detect a short circuit the voltage drop across at least one first resistor (1) or a second resistor (8) is detected by a control unit (27) .

12. Method for operating a sensor (2) according to Claim 11, wherein the one or more voltage drops are compared with threshold values in order to detect a short circuit.

13. Method for operating a sensor (2) according to Claim 11, wherein the change in at least one voltage drop is compared with at least one threshold value in order to detect a short circuit.

14. Method for operating a sensor (2) according to Claim 11, wherein by means of two voltage drops detected across a first resistor (1) or a second resistor (8) the currents through the first resistor (1) and/or the second resistor (8) are calculated in a control unit (27) and by comparing the difference between the currents a short circuit can be detected.

## Revendications

1. Appareil de commande (6) permettant d'évaluer le signal de capteur d'un capteur (2) présentant au moins un premier connecteur de capteur (21) et un deuxième connecteur de capteur (22) pour connecter le capteur (2), l'appareil de commande comprenant un circuit de protection contre les courts-circuits (23) et le deuxième connecteur de capteur (22) étant relié au circuit de protection contre les courts-circuits (23) qui est disposé entre le deuxième connecteur de capteur (22) et une prise de terre (3) et qui comprend un transistor commutable (7) qui permet d'interrompre la prise de terre (3) du deuxième connecteur de capteur (22) .

2. Appareil de commande (6) selon la revendication 1, dans lequel le premier connecteur de capteur (21) est conçu pour connecter le capteur (2) et pour fournir une tension de capteur pour le fonctionnement du capteur (2), le premier connecteur de capteur (21) étant connecté à une source de tension d'alimentation (5).

3. Appareil de commande (6) selon la revendication 2, dans lequel une première résistance (1) est disposée entre la source de tension d'alimentation (5) et le capteur (2).

4. Appareil de commande (6), selon l'une quelconque des revendications précédentes, dans lequel le transistor (7) est disposé sur un chemin d'interruption (25) sur lequel se trouve une deuxième résistance (8) à basse impédance en série avec le transistor (7).

5. Appareil de commande (6) selon l'une quelconque des revendications précédentes, dans lequel le circuit de protection contre les courts-circuits (23) présente un chemin de shuntage (24) qui shunte le transistor (7) et sur lequel se trouve une troisième résistance (9) à haute impédance.

6. Appareil de commande (6) selon l'une quelconque des revendications précédentes, comprenant un circuit d'évaluation (10) auquel est relié au moins le premier connecteur de capteur (21), et qui est conçu pour évaluer un signal de capteur d'un capteur (2) connecté au premier connecteur de capteur (21).

7. Appareil de commande (6) selon la revendication 6, dans lequel le circuit d'évaluation (10) est en plus relié au deuxième connecteur de capteur (22), et peut lors de l'évaluation d'un signal de capteur d'un capteur relié au premier connecteur de capteur (21) et au deuxième connecteur de capteur (22) accéder au choix à une tension de capteur (16) entre le premier connecteur de capteur (21) et une prise de terre (3) ou à une tension de capteur (16) entre le premier connecteur de capteur (21) et le deuxième connecteur de capteur (22).

8. Appareil de commande (6) selon l'une quelconque des revendications précédentes, comprenant un circuit de pilotage (11) qui permet de piloter le circuit de protection contre les courts-circuits (23) afin d'empêcher un court-circuit.

9. Appareil de commande (6) selon la revendication 8, dans lequel le circuit de pilotage (11) est conçu pour interrompre le circuit de protection contre les courts-circuits (23) s'il existe une différence inattendue entre un premier signal de capteur (14) au niveau d'un premier connecteur de capteur (21) et une prise de terre (3) et un deuxième signal de capteur (15) entre le premier connecteur de capteur (21) et le deuxième connecteur de capteur (22).

10. Procédé permettant de faire fonctionner un capteur (2) avec un appareil de commande (6) selon l'une quelconque des revendications précédentes, présentant au moins l'une des mesures suivantes :
- fermeture du transistor s'il a été identifié qu'aucun court-circuit n'existe,
- ouverture du transistor s'il a été identifié qu'un court-circuit existe,
- fermeture du transistor avant un instant de mesure, exécution d'une mesure par le capteur et ouverture consécutive du transistor.

11. Procédé permettant de faire fonctionner un capteur (2) selon la revendication 10, dans lequel, pour identifier un court-circuit, la chute de tension aux bornes d'au moins une première résistance (1) ou d'une deuxième résistance (8) est détectée par un appareil de commande (27).

12. Procédé permettant de faire fonctionner un capteur (2) selon la revendication 11, dans lequel la ou les chutes de tension est/sont comparée(s) à des valeurs seuil afin d'identifier un court-circuit.

13. Procédé permettant de faire fonctionner un capteur (2) selon la revendication 11, dans lequel la variation d'au moins une chute de tension est comparée avec au moins une valeur seuil afin d'identifier un court-circuit.

14. Procédé permettant de faire fonctionner un capteur (2) selon la revendication 11, dans lequel les courants passant à travers la première résistance (1) ou la deuxième résistance (8) dans un appareil de commande (27) sont calculés au moyen de deux chutes de tension détectées aux bornes d'une première résistance (1) ou d'une deuxième résistance (8), et un court-circuit peut être identifié par la comparaison de la différence des courants.
